# FASCICULE DE BREVET EUROPEEN

(11) **EP 3 011 584 B1**
(45) Date de publication et mention de la délivrance du brevet: **20.09.2017**
(21) Numéro de dépôt: 14739880.4
(22) Date de dépôt: 17.06.2014
(51) Int. Cl.: H01J 49/12, H01J 37/32

(54) **PROCÉDÉ ET DISPOSITIF DE SPECTROMÉTRIE DE MASSE À DÉCHARGE LUMINESCENTE**
GLIMMENTLADUNGSMASSENSPEKTROMETRIEVERFAHREN UND -VORRICHTUNG
GLOW DISCHARGE MASS SPECTROMETRY METHOD AND DEVICE

(30) Priorité: 17.06.2013 FR 1355667
(43) Date de publication de la demande: 27.04.2016
(73) Titulaire: Horiba Jobin Yvon S.A.S., 91160 Longjumeau (FR)
(72) Inventeur: CHAPON, Patrick, F-91440 Villebon sur Yvette (FR); LEGENDRE, Sébastien, F-78280 Guyancourt (FR)
(74) Mandataire: Jacobacci Coralis Harle
(86) Numéro de dépôt international: PCT/FR2014/051493
(87) Numéro de publication internationale: WO 2014/202892

(56) Documents cités:
- FR-A1- 2 959 015
- JP-A- S6 215 747
- US-A1- 2004 118 436
- US-A1- 2007 272 852
- "Norm ISO - 15338 / Analyse chimique des surfaces -- Spectrométrie de masse GBP a décharge luminescente (GD-MS) -- Introduction GBP a l'utilisation / Surface chemical analysis - Glow discharge mass spectrometry (GD-MS) - Introduction to use", INTERNATIONAL STANDARD ISO/IEC, XX, XX, vol. Norm ISO - 15338, 1 janvier 2009 (2009-01-01), page 30pp, XP008169139, cité dans la demande

## Description

La présente invention se rapporte aux dispositifs et procédés de spectrométrie de masse à décharge luminescente (GD-MS pour Glow Discharge Mass Spectrometry). Plus précisément, l'invention concerne un procédé de GD-MS comprenant une étape de nettoyage ou de décontamination de la lampe à décharge luminescente et de la surface de l'échantillon à analyser.

La spectrométrie de masse à décharge luminescente est une technique d'analyse qui permet de mesurer la composition chimique élémentaire et/ou moléculaire d'échantillons solides homogènes ou multicouches. La mesure peut se faire à coeur ou être résolue en profondeur.

Le principe de la GD-MS consiste à éroder une surface relativement étendue d'un échantillon par plasma, puis à ioniser les espèces chimiques érodées et à détecter les ions par spectrométrie de masse pour en déduire la composition de l'échantillon. Plus précisément, un gaz, dit gaz de plasma, est injecté dans la lampe à décharge et une puissance électrique est appliquée entre l'anode et la cathode de la lampe pour générer un plasma. Le gaz de plasma est généralement un gaz inerte tel que de l'argon, du néon, du krypton ou de l'hélium. Le gaz de plasma peut aussi est formé d'un mélange de gaz par exemple un mélange d'argon et d'un autre gaz tel que l'oxygène, l'hydrogène ou l'hélium. La surface de l'échantillon placé dans la lampe est ainsi exposée à un plasma d'ablation. Ce plasma assure à la fois l'érosion du matériau solide à analyser ainsi que l'excitation et/ou l'ionisation des espèces érodées en phase gazeuse. Un spectromètre permet d'analyser les espèces chimiques présentes dans le plasma. En fonction de la durée d'érosion, la GD-MS permet une analyse de certains échantillons résolue en profondeur fournissant ainsi un profil de composition.

La technique de spectrométrie de masse à décharge luminescente repose sur le couplage d'une lampe à décharge luminescente et d'un spectromètre de masse. Il existe différents appareils de spectrométrie de masse à décharge luminescente nommés selon le type de lampe de décharge luminescente et le type de spectromètre utilisé.

On utilise notamment un spectromètre de masse à secteur magnétique ou HR-GD-MS ou un spectromètre de masse à temps de vol ou GD-TOFMS.

En spectrométrie de masse de décharge luminescente (GD-MS), un spectromètre de masse permet d'analyser les espèces chimiques ionisées du plasma en fonction de leur ratio m/z où m représente la masse et z la charge électrique de l'espèce ionisée. L'analyseur de masse sépare et transfère les ions vers un détecteur. Les ions détectés génèrent un courant électrique qui est mesuré. L'instrument calcule ensuite la fraction élémentaire d'ions prédéterminés, éventuellement par comparaison avec les signaux générés par un échantillon de composition connue. La HR-GD-MS classique à secteur magnétique s'applique principalement à l'analyse de matériaux métalliques conducteurs, et permet de détecter la présence d'éléments à l'état de traces à des niveaux sub-ppb.

En spectrométrie de masse à temps de vol de décharge luminescente (GD-TOFMS), le spectromètre de masse reçoit un flux d'espèces ionisées du plasma et sépare temporellement les espèces ionisées en fonction de leur rapport masse sur charge (m/z). Couplé à un détecteur multicanal, l'analyseur de masse à temps de vol permet ainsi de détecter simultanément ou quasi-simultanément tous les éléments chimiques du spectre de masse de la source d'ions et de mesurer les flux d'ions avec une bonne résolution et à une haute fréquence d'acquisition. La GD-TOFMS permet une analyse du profil élémentaire et moléculaire de matériaux résolue en profondeur. Pour les applications de mesure élémentaire à coeur de matériaux solides la spectrométrie de masse à temps de vol est moins sensible que la HR-GD-MS classique, mais elle couvre un champ d'application immensément plus vaste.

La GD-MS est relativement simple d'utilisation et a des applications variées. Elle permet l'analyse d'éléments présents sous forme de traces, mineurs et majeurs dans des échantillons solides métalliques ou non- métalliques.

Toutefois, pour atteindre un niveau élevé de sensibilité et de précision, en particulier à la surface d'un échantillon, il est essentiel de fournir des conditions de plasma stables dès le début de l'érosion du matériau.

Dans un mode de fonctionnement classique en GD-TOFMS, le matériau à analyser est généralement placé face à la source ou lampe à décharge luminescente contre un joint torique assurant l'étanchéité. Un système de pompage permet d'obtenir un vide primaire dans la source GD. Une source de gaz, par exemple une bouteille d'argon ou d'un mélange de gaz, permet d'injecter un flux de gaz de plasma dans la lampe à décharge. L'équilibre entre le débit du système de pompage et le débit du gaz de plasma assure le maintien d'une pression de quelques torrs dans la source GD. Le plasma est alors allumé dans la source GD dans des conditions de pression relativement faible, mais pas dans des conditions de vide poussé.

Toutefois, la présence de contaminants dans le gaz de plasma, sur la surface de l'échantillon à analyser ou sur les parois internes de la lampe à décharge est susceptible d'induire des instabilités dans le plasma et des erreurs de mesure en spectrométrie de masse à décharge luminescente, quelle que soit la méthode de mesure : spectrométrie de masse avec secteur magnétique ou à temps de vol.

En particulier, des impuretés gazeuses telles que l'azote, l'oxygène, ou encore des hydrocarbures et l'eau peuvent conduire à la production de signaux parasites dus à des ions CO⁺, CO₂⁺, H₃O⁺, ArC, ArCO⁺, ArH⁺ et à des recombinaisons de ces ions, ou encore à des ions MO⁺ et MH⁺, où M représente un métal à analyser.

Or ces espèces peuvent générer des signaux parasites ou des signaux interférents avec les signaux recherchés. De plus, ces signaux interférents ne sont pas seulement présents à l'allumage du plasma, mais peuvent apparaître plusieurs dizaines de secondes après le démarrage du plasma d'ablation. Ces signaux parasites ou interférents peuvent conduire à des erreurs d'interprétation des mesures de spectrométrie, notamment dans le cas d'analyse par spectrométrie de masse résolue en fonction de la profondeur du cratère d'érosion.

En particulier dans les applications d'analyse de surface, le suivi des éléments comprenant de l'hydrogène (H) et/ou de l'oxygène (O) est crucial. Par exemple, on peut citer l'analyse de couches oxydées en surface d'un échantillon. L'apparition de certains signaux peut conduire à l'interprétation d'une couche enterrée sous la surface de l'échantillon, alors qu'il s'agit en réalité de signaux parasites de contamination.

Il est donc essentiel que les mesures de GD-MS ne présentent aucune ambiguïté.

En outre, la présence d'espèces hydratées entraîne, par recombinaison, des interférences isobariques sur d'autres éléments clés. Par exemple, dans le cas de l'analyse d'un métal M par GDMS, le ratio m/z d'un ion composé NH₂0⁺ peut être très proche du ratio de l'ion du métal M recherché (si l'ion N a une masse proche de la masse de l'ion M moins 18). L'ion composé que l'on appellera pour simplifier ici (M-18)H₂0⁺ produit alors un signal d'interférence qui peut fausser l'interprétation des mesures. Ces espèces hydratées doivent donc être contrôlées.

Enfin, les contaminants génèrent un bruit de fond instable qui affecte la reproductibilité des mesures de GD-MS.

Un dispositif classique utilisé pour réduire les effets des impuretés en HR-GD-MS consiste à refroidir l'échantillon et les parois de la source.

La norme ISO15338 définit un ensemble de recommandations visant à standardiser les pratiques dans l'analyse chimique de surface par spectrométrie de masse à décharge luminescente. Selon cette norme, la mise en oeuvre d'un refroidissement cryogénique de l'enceinte de la lampe à décharge luminescente permet de réduire les impuretés gazeuses (9.1.2 *in fine*).

D'autre part, le document de brevet FR2884964-A1 décrit l'utilisation de modules Peltier pour refroidir directement ou indirectement l'échantillon à analyser. Ces modules Peltier permettent de réguler la température de l'échantillon dans une gamme de températures inférieure à 270K et allant jusqu'à 70K. Le refroidissement de l'échantillon permet de stabiliser la température de l'échantillon au cours de l'exposition au plasma de manière à augmenter la précision et la reproductibilité des résultats de mesure. Ce refroidissement évite d'endommager la structure de l'échantillon, du fait de l'échauffement induit par le plasma d'ablation, notamment dans le cas d'échantillons organiques ou en couches minces.

Ces dispositifs de refroidissement sont certes efficaces mais contraignants. En effet, après la mesure de HR-GD-MS, une étape de remise à température ambiante de chaque échantillon est généralement nécessaire avant l'ouverture de la lampe, par exemple pour un changement d'échantillon. Cette remise à température ambiante de l'échantillon a pour but d'éviter les phénomènes de condensation dus en particulier à la présence d'humidité dans l'air ambiant. Cette étape de remise à température ambiante peut prendre une dizaine de minutes pour chaque échantillon et limite grandement la cadence des mesures de HR-GD-MS à quelques échantillons à l'heure (environ 3 échantillons). De plus le refroidissement de l'échantillon implique des contraintes mécaniques, par exemple de tenue en température des joints d'étanchéité.

La norme ISO 15338 recommande une étape de pulvérisation préliminaire (pre-sputtering) d'une certaine durée entre l'allumage du plasma et le début de la mesure de HR-GD-MS, dans le but d'enlever les contaminants de la surface de l'échantillon avant le début de l'analyse par spectrométrie de masse. Cette étape de pulvérisation préliminaire permet d'éliminer certaines interférences de surface.

Toutefois, des contaminants peuvent subsister malgré cette étape de pulvérisation préliminaire. De plus, cette étape de pulvérisation préliminaire est inapplicable lorsqu'on souhaite effectuer une analyse de profil de composition de l'échantillon résolue en profondeur (depth-profile) où la surface de l'échantillon est pertinente pour l'analyse.

Un des objectifs de l'invention est de réduire la quantité d'espèces contaminantes absorbées ou adsorbées par l'échantillon à analyser et/ou par les parois de la cellule où se forme le plasma de la source à décharge luminescente. Un autre but de l'invention est de fournir un procédé de spectrométrie de masse à décharge luminescente dans lequel les contaminants sont en nombre réduit, sans allonger la durée de traitement d'un échantillon dans un spectromètre de décharge luminescente.

Il est souhaitable de proposer un appareil de spectrométrie de masse à décharge luminescente qui permet de minimiser grandement les résidus d'eau tout en gardant la simplicité d'utilisation des appareils GD-TOFMS.

La présente invention a pour but de remédier à ces inconvénients et concerne plus particulièrement un procédé de spectrométrie de masse à décharge luminescente comprenant les étapes suivantes :
a. Mise en place d'un échantillon à analyser par spectrométrie de masse à décharge luminescente dans une cellule d'une lampe à décharge luminescente ;
b. Pompage d'un flux d'espèces gazeuses hors de ladite cellule ;
c. Injection d'un flux de gaz de plasma dans ladite cellule ;
d. Application d'une puissance électrique sur les électrodes de la cellule de décharge luminescente de manière à allumer un plasma d'ablation en surface de l'échantillon à analyser ;
e. Détection des espèces ionisées du plasma, analyse desdites espèces ionisées et mesure des espèces détectées par spectrométrie de masse à décharge luminescente.

Selon l'invention, le procédé de spectrométrie de masse à décharge luminescente comporte en outre les étapes suivantes :
f. chauffage d'un flux de gaz à une température T supérieure à la température ambiante, supérieure à la température de l'échantillon et/ou supérieure à la température interne de la cellule ;
g. injection, dans la cellule de décharge luminescente, dudit flux de gaz chauffé à la température T pendant une durée D, avant l'étape d) d'allumage du plasma d'ablation, et
h. pompage d'un flux d'espèces gazeuses hors de ladite cellule pendant la durée D, de manière à décontaminer la surface de l'échantillon et/ou les parois internes de la cellule de décharge luminescente avant l'allumage du plasma d'ablation.

L'injection d'un flux de gaz chauffé, même à une température T modérée d'environ 320K, permet de faire désorber les molécules contaminantes de la surface de l'échantillon et de l'intérieur du circuit fluidique, comprenant les tuyaux d'arrivée de gaz, l'enceinte de la cellule de décharge luminescente, et les tuyaux de pompage. Le pompage des espèces désorbées par le flux de gaz chauffé permet d'évacuer les espèces contaminantes désorbées en dehors de la cellule de décharge luminescente.

De façon particulièrement avantageuse, l'injection d'un gaz chaud est effectuée pendant la période de purge du système avant l'allumage du plasma et ne retarde nullement le procédé de mesure de GD-MS. L'injection de gaz chauffé est particulièrement efficace pour la désorption de molécules d'eau, et permet de réduire fortement l'apparition d'espèces parasites hydratées ou d'ions oxygène qui sont en pratique les plus gênants.

Selon différents aspects particuliers et avantageux du procédé de l'invention :
- le gaz chauffé injecté à l'étape g) a la même composition chimique que le gaz de plasma, de préférence choisi parmi un gaz rare ou un mélange de gaz rares ou un mélange d'un gaz rare et d'un autre gaz ;
- le gaz chauffé injecté à l'étape g) a une composition chimique différente du gaz de plasma ;
- la température T du gaz chauffé est comprise entre 300 K et 400 K, voire entre 310 et 360K, et de préférence d'environ 323 ± 10 K ;
- la durée D est comprise entre quelques secondes et quelques minutes ;
- l'étape e) comporte une étape de détection et de mesure d'espèces ionisées contaminantes parmi les espèces hydratées et/ou les espèces oxygénées.

Selon un mode de réalisation particulier, le procédé comporte en outre suite à l'étape h), une étape d'interruption de l'injection d'un flux de gaz dans la cellule et une étape de pompage sous vide de la cellule avant les étapes c) d'injection d'un flux de gaz de plasma et d) d'allumage du plasma d'ablation. Plus particulièrement, dans un procédé de spectrométrie de masse à temps de vol, l'étape de pompage sous vide de la cellule comprend l'ouverture d'une fente disposée entre la cellule et le spectromètre de masse à temps de vol et le pompage sous vide de ladite cellule via des moyens de pompage du spectromètre de masse à temps de vol.

L'invention concerne aussi un dispositif de spectrométrie de masse à décharge luminescente comprenant :
- une lampe à décharge luminescente, comprenant une cellule de décharge luminescente, des électrodes, et une source d'alimentation électrique adaptée pour appliquer une puissance électrique sur les électrodes de la cellule de décharge luminescente, des moyens d'injection d'un flux de gaz dans la cellule de décharge luminescente, lesdits moyens d'injection étant reliés à la cellule de décharge luminescente par des moyens de raccordement fluidiques et des moyens de pompage d'un flux d'espèces gazeuses hors de la cellule de décharge luminescente, ladite lampe à décharge luminescente étant adaptée pour former un plasma d'ablation en surface d'un échantillon à analyser en présence d'un flux de gaz de plasma dans la cellule de décharge luminescente, et
- un spectromètre de masse comprenant un détecteur adapté pour détecter des espèces ionisées du plasma.

Selon l'invention, le dispositif de spectrométrie de masse à décharge luminescente comporte en outre des moyens de chauffage adaptés pour chauffer un flux de gaz en amont de ladite cellule de décharge luminescente, les moyens d'injection de gaz étant adaptés pour injecter, dans la cellule de décharge luminescente, un flux de gaz chauffé à la température T pendant une durée D, et en ce que les moyens de pompage sont configurés pour pomper un flux d'espèces gazeuses hors de ladite cellule pendant la durée D, de manière à décontaminer la surface de l'échantillon et/ou les parois internes de la cellule de décharge luminescente avant l'allumage du plasma d'ablation.

Selon différents aspects particuliers et avantageux du dispositif de l'invention :
- les moyens de chauffage sont adaptés pour chauffer un flux de gaz à une température comprise entre 300 K et 400 K, voire entre 310 et 360K, et de préférence d'environ 323 ± 10 K ;
- les moyens de chauffage d'un flux de gaz comprennent une résistance électrique chauffante, une source de flux d'air chauffé ou une source de liquide chauffé, lesdits moyens de chauffage étant disposés au voisinage d'une conduite de gaz reliant une source de gaz à la cellule de décharge luminescente.

De façon avantageuse, le dispositif comporte en outre des moyens de refroidissement adaptés pour refroidir l'échantillon et/ou la cellule de décharge luminescente.

L'invention trouvera une application particulièrement avantageuse en spectrométrie de masse à décharge luminescente appliquée à l'analyse résolue en profondeur de matériaux et de couches minces.

La présente invention concerne aussi un dispositif de spectrométrie de masse à décharge luminescente comprenant une lampe à décharge luminescente, comprenant une cellule de décharge luminescente, des électrodes, et une source d'alimentation électrique adaptée pour appliquer une puissance électrique sur les électrodes de la cellule de décharge luminescente, des moyens d'injection d'un flux de gaz de plasma dans la cellule de décharge luminescente, lesdits moyens d'injection étant reliés à la cellule de décharge luminescente par des moyens de raccordement fluidiques et des moyens de pompage d'un flux d'espèces gazeuses hors de la cellule de décharge luminescente, ladite lampe à décharge luminescente étant adaptée pour former un plasma d'ablation en présence d'un gaz de plasma dans la cellule de décharge luminescente et un spectromètre comprenant un détecteur adapté pour détecter des espèces excitées et/ou ionisées du plasma.

Selon l'invention, le dispositif de spectrométrie de masse à décharge luminescente comporte en outre des moyens d'injection de gaz chauffé adaptés pour injecter, dans la cellule de décharge luminescente, un flux de gaz chauffé à une température T pendant une durée D, la durée D et la température T étant adaptées pour décontaminer l'échantillon et/ou les parois internes de la cellule de décharge luminescente avant le démarrage du plasma d'ablation.

La présente invention concerne également les caractéristiques qui ressortiront au cours de la description qui va suivre et qui devront être considérées isolément ou selon toutes leurs combinaisons techniquement possibles.

L'invention propose ainsi un procédé permettant de réduire les effets négatifs induits par des contaminants tels que notamment des molécules d'eau adsorbés sur la surface d'un échantillon à analyser ou sur les parois intérieures d'une lampe à décharge luminescente.

Cette description donnée à titre d'exemple non limitatif fera mieux comprendre comment l'invention peut être réalisée en référence aux dessins annexés sur lesquels :
- la figure 1 représente schématiquement une vue en coupe d'une lampe à décharge luminescente selon l'état antérieur de la technique ;
- la figure 2 représente un exemple de mesure du profil en profondeur d'un échantillon d'inox homogène par GD-TOFMS selon l'art antérieur ;
- la figure 3 représente schématiquement un dispositif de spectrométrie de masse à décharge luminescente selon un mode de réalisation de l'invention ;
- la figure 4 représente des mesures par GD-TOFMS de signaux correspondant à l'ion H₃O⁺ lors de l'exposition d'un échantillon à un plasma de décharge luminescente GD, respectivement sans et avec chauffage du gaz injecté dans la source avant le démarrage du plasma ;
- la figure 5 représente schématiquement un diagramme d'étapes de procédé de spectrométrie de masse à décharge luminescente selon différentes variantes du procédé de l'invention.

Il existe différents appareil de spectrométrie de masse à décharge luminescente (GD-MS pour Glow Discharge Mass Spectrometer). Un appareil de GD-MS comprend généralement un dispositif mécanique dit « lampe » dans lequel est placé un échantillon à analyser, le corps de la lampe étant relié à un spectromètre de masse.

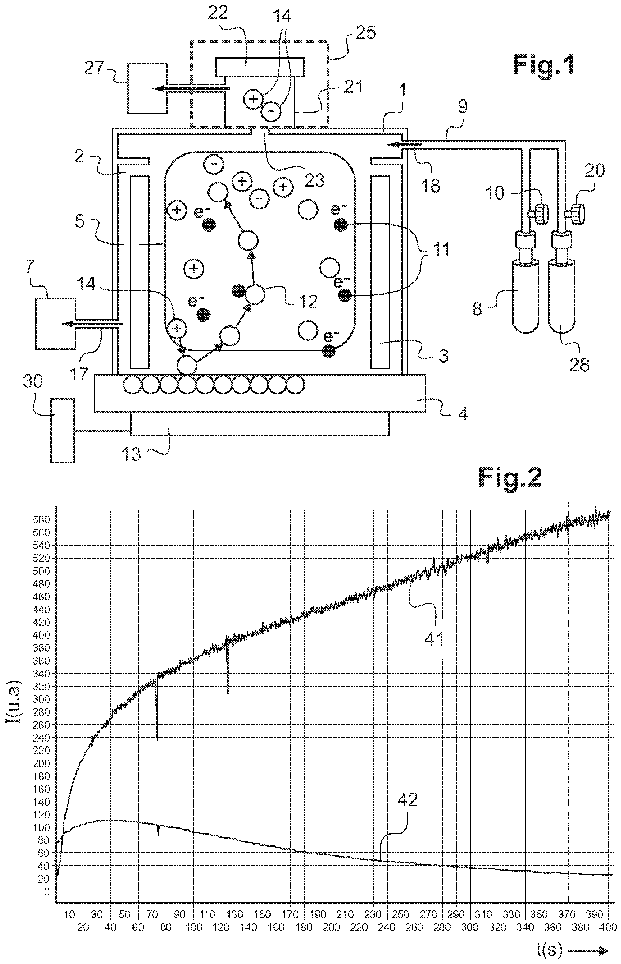

La figure 1 représente schématiquement une vue en coupe transversale d'une lampe à décharge selon l'état de la technique. La lampe à décharge 1 de type tube anodique RF comprend un tube anodique 3 à l'intérieur d'une enceinte à vide 2. Un échantillon 4 placé dans la lampe face à une extrémité du tube anodique 3 forme la deuxième électrode du dispositif. Un joint disposé entre l'échantillon et le corps de la lampe assure généralement l'étanchéité de la cellule de décharge luminescente.

Dans le présent document, on entend de manière équivalente le terme cellule et l'expression enceinte à vide d'une lampe à décharge luminescente.

Un système de pompage 7 permet d'effectuer un vide primaire dans la lampe à décharge après la mise en place de l'échantillon pour évacuer l'air ambiant de la cellule de décharge luminescente via un raccordement fluidique. Une source de gaz 8 est reliée par un raccordement fluidique 9 (plus précisément une conduite d'injection de gaz) à l'enceinte à vide 2 de la lampe à décharge luminescente, pour permettre l'injection d'un gaz de plasma 18 sous faible pression. Le gaz de plasma 18 est généralement un gaz inerte et préférentiellement de l'argon, ou un mélange d'un gaz inerte et d'un autre gaz. La source de gaz est par exemple une bouteille 8 de gaz purifié, dont le taux de contaminants est inférieur à un seuil déterminé, par exemple de 5ppm. Une vanne 10 permet d'ouvrir ou de fermer l'alimentation en gaz. A titre d'exemple non limitatif, la source de gaz peut être constituée d'une mélange de gaz provenant par exemple de deux bouteilles 8, 28 de gaz différents. La deuxième bouteille de gaz 28 est aussi reliée à une vanne 20. Le contrôle des vannes 10 et 20 permet d'ajuster la composition du mélange de gaz de plasma 18 injecté dans l'enceinte de la lampe à décharge pour former un plasma 5 d'ablation. Le pompage est maintenu pendant le plasma de manière à évacuer un flux d'espèces gazeuses ou flux de pompage 17. Le flux du gaz de plasma 18 et le flux de pompage 17 sont régulés de manière à maintenir la pression dans l'enceinte 2 de la lampe à décharge à un niveau relativement faible et stable. Un générateur électrique 30 permet d'appliquer une puissance électrique les électrodes de la lampe afin de générer un plasma 5. Par exemple, le tube anodique 3 étant relié à la masse, un applicateur 13 en contact avec la face arrière de l'échantillon délivre la puissance électrique nécessaire pour maintenir un plasma d'ablation 5. Le plasma 5 est généralement constitué d'électrons 11, d'atomes neutres dans un état fondamental ou excité 12 et d'espèces ionisées 14. Le plasma 5 reste confiné à l'intérieur du tube anodique 3. Par bombardement ionique, le plasma 5 érode la surface de l'échantillon 4 disposé face à l'extrémité du tube anodique. Par érosion, ce plasma 5 forme en surface de l'échantillon un cratère dont le diamètre est proche du diamètre intérieur du tube anodique. Les espèces ionisées 14 présentes dans le plasma 5 sont détectées et mesurées par un spectromètre de masse 25 via une ouverture 23 entre la cellule et le spectromètre de masse 25. Plus particulièrement, un spectromètre de masse à temps de vol comprend un analyseur de masse à temps de vol 21 et un détecteur d'ions 22. L'analyseur de masse 21 sépare les ions en fonction de leur rapport masse sur charge (m/z), où m représente la masse atomique et z la charge électrique d'une espèce ionisée. Le détecteur d'ions 22 compte les ions en fonction du temps.

Le spectromètre de masse est en communication avec la lampe à décharge luminescente via une ouverture 23 pour permettre le passage des ions 14 du plasma d'ablation 5. Un système de pompage différentiel 27 couplé au spectromètre de masse 25 permet généralement d'atteindre un vide secondaire (10⁻⁵ Pa) à l'intérieur du spectromètre de masse, alors que l'enceinte à vide 2 de la lampe à décharge est généralement pompée sous vide primaire (10⁻¹ Pa) via la pompe 7 et un gaz y est introduit de manière contrôlée pour que la pression s'établisse autour de 665 Pa.

Un spectromètre de masse à décharge luminescente permet ainsi l'analyse de matériaux solides homogènes, l'analyse de dépôts en surface de matériaux solides, et l'analyse d'empilements de couches minces. Toutefois, la vitesse d'érosion des sources GD-MS étant relativement élevée (de l'ordre de 2 à 100 nm par seconde), il est nécessaire de disposer de spectromètres permettant une acquisition rapide et fournissant des informations multi-élémentaires. Ceci peut être obtenu en utilisant un spectromètre de masse à temps de vol extrêmement rapide.

La figure 2 illustre un exemple d'analyse du profil de composition en profondeur d'un échantillon d'inox homogène par GD-TOFMS en fonction du temps d'exposition au plasma de décharge luminescente. L'analyseur du spectromètre est configuré pour mesurer plus particulièrement les signaux correspondant à l'élément métallique ferreux ⁵⁶Fe sur la courbe 41 et à la molécule d'eau ¹⁸H₂O sur la courbe 42, respectivement. Sur la courbe 41 représentant l'élément ferreux, on observe une augmentation continue du signal de l'ion fer en fonction du temps, qui correspond à l'allure du signal de GD-TOFMS attendu pour un échantillon métallique uniforme en profondeur.

Sur la courbe 42 de la figure 2 correspondant à l'ion H₃O⁺ (molécule d'eau), on observe une augmentation lente du signal jusqu'à un maximum du signal au bout d'une durée du plasma d'ablation d'environ 40 s, puis une décroissance lente qui se poursuit pendant plusieurs minutes. Toutefois, on constate que le niveau de la courbe représentant l'eau reste à un niveau relativement élevé même après plusieurs minutes de plasma de décharge luminescente.

La mesure du seul signal de GD-TOFMS de l'élément eau (courbe 42) peut conduire à une mauvaise interprétation, en attribuant le maximum vers 40s. à des inhomogénéités en profondeur de la composition de l'échantillon.

Le maximum observé sur la courbe 42 est très probablement un signal dû à la désorption de molécules d'eau provenant des parois de la cellule à décharge luminescente, suite à l'échauffement induit par le plasma.

Les sources de contamination, en particulier la contamination par des molécules d'eau, induisent donc non seulement des pics parasites mais aussi du bruit de fond qui fausse les mesures de spectrométrie de masse à décharge luminescente.

De plus, les composés hydratés s'ionisent très facilement dans le plasma. Ce signal dû aux molécules d'eau ¹⁸H₂O est donc très néfaste pour l'interprétation correcte d'un profil. En outre la présence d'espèces hydratées entraine des interférences isobariques sur d'autres éléments clés (par recombinaison), ces espèces hydratées doivent donc être contrôlées.

Enfin, pour l'application à l'analyse de surface, le suivi des éléments H, O et leurs combinaisons dans les échantillons à analyser est crucial, par exemple dans le suivi de couches oxydées. Il est donc essentiel que la mesure ne présente aucune ambigüité entre les éléments H, O (et leurs combinaisons) provenant du matériau de surface de l'échantillon à analyser d'une part et d'autre part les contaminants provenant des parois ou adsorbés en surface de l'échantillon.

Comme indiqué précédemment, il existe des dispositifs utilisant des moyens de refroidissement de la source à décharge luminescente. Ces dispositifs utilisent de moyens de refroidissement, par circulation d'eau ou par module(s) à effet Peltier configurés pour produire un refroidissement. Ces moyens de refroidissement évacuent la chaleur induite par le plasma sur les parois internes de la source et évitent ainsi tout échauffement des parois. Les contaminants adsorbés sur les parois ne sont alors pas désorbés ou dégazés.

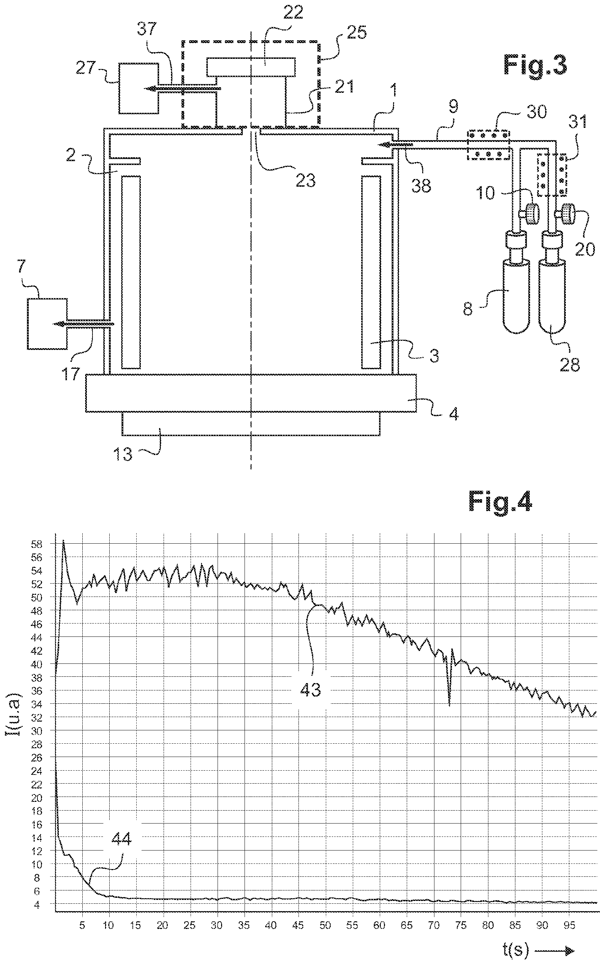

La figure 3 représente schématiquement un dispositif de spectrométrie de masse à décharge luminescente selon un mode de réalisation de l'invention.

Le dispositif est analogue à celui de la figure 1 et comporte en outre des moyens de chauffage 30 et/ou 31 adaptés pour chauffer un flux de gaz 38 injecté dans l'enceinte de la lampe à décharge 1 avant l'allumage du plasma d'ablation 5. A titre d'exemple, un moyen de chauffage 31 est situé à proximité d'une conduite de gaz reliée à la source de gaz 28 en aval de la vanne 20. Un autre moyen de chauffage 30 est situé sur la conduite de gaz commune aux deux sources de gaz 8 et 28. Avantageusement, les sources de gaz peuvent être les mêmes sources de gaz que celles utilisées pour générer le plasma d'ablation 5 et pour l'analyse de l'échantillon 4 par spectrométrie de masse de décharge luminescente. Avantageusement, les sources de gaz peuvent être les mêmes sources de gaz que celles utilisées pour purger la lampe à décharge luminescente. Dans une autre variante, la(les) source(s) du flux de gaz chauffé 38 sont différentes de la(les) source(s) du gaz de plasma, le gaz de chauffage pouvant être moins onéreux que le gaz d'analyse, par exemple de l'argon moins pur que de l'azote.

Dans le dispositif de l'invention, tel que représenté schématiquement sur la figure 3, un chauffage de gaz est assuré par la mise en place d'un moyen de chauffage 30 et/ou 31 situé le long de la ligne d'arrivée de gaz 9 qui permet d'injecter un gaz chauffé 38 dans la lampe à décharge luminescente avant l'allumage du plasma d'ablation. La conduite de gaz 9 est généralement en inox. Cette conduite de gaz 9 est reliée à l'enceinte à vide 2 de la lampe à décharge 1 par un raccord fluidique.

Dans un mode de réalisation particulier, le moyen de chauffage 30 comprend une résistance électrique chauffante disposée autour de la conduite de gaz 9. A titre d'exemple, une résistance électrique chauffante d'une puissance de quelques dizaines à une centaine de Watt convient pour chauffer un tube inox d'une conduite de gaz et pour chauffer par conduction un flux de gaz 38 se propageant à l'intérieur de la conduite de gaz pour être ensuite injecté dans l'enceinte à vide 2 de la lampe à décharge luminescente. Dans un exemple de réalisation, la conduite de gaz est ainsi portée à une température de 310 à 330 K, qui évite les brûlures par contact de l'opérateur.

Dans une autre variante, le moyen de chauffage 30 peut être constitué d'un flux d'air chauffé, ou d'un passage de la conduite de gaz 9 dans un récipient contenant un liquide chauffé à une température déterminée. L'homme du métier adaptera aisément le moyen de chauffage le plus adapté au montage.

Les moyens de chauffage peuvent comprendre une ou plusieurs résistances électriques 30, 31 disposés au voisinage d'une ou de plusieurs lignes de gaz.

Le moyen de chauffage 30 permet d'amener la température du gaz à une température T supérieure à la température ambiante, autour de 292 K.

Avantageusement, la température T du flux de gaz chauffé 38 est comprise entre 300 K et 400 K.

De préférence, la température T du flux de gaz chauffé 38 est comprise entre 310K et 360 K, ce qui permet de limiter la consommation énergétique du chauffage.

Dans un mode de réalisation préféré, la température T du flux de gaz ainsi chauffé est d'environ 320 K ±10 K, ce qui évite tout risque d'endommagement des joints d'étanchéité et des composants électroniques de la lampe.

La température T relativement faible évite toute dégradation des joints d'étanchéité ou des composants électroniques de la lampe à décharge luminescente.

Une régulation de la température T n'est pas indispensable. En effet, le procédé s'avère tolérant aux variations de la température de chauffage.

De façon avantageuse, le moyen de chauffage 30 est éloigné de la lampe à décharge et disposé à proximité de la ou des source(s) de gaz 8, 28. Par exemple, dans le cas où la source de gaz comporte une bouteille de gaz 28, il est particulièrement avantageux de disposer un moyen de chauffage 31 en aval de la vanne de dilatation 20 du gaz. En effet, le gaz est généralement stocké dans une bouteille sous forte pression (10⁷ à 2. 10⁷ Pa) et est injecté dans la lampe à décharge luminescente sous une pression beaucoup plus faible (quelques milli torrs). Or, du fait de la dilatation, le gaz se refroidit. Par condensation, le gaz refroidi contribue à condenser des espèces telles que les molécules d'eau à l'intérieur des lignes de gaz et à l'intérieur de l'enceinte 2 de la lampe à décharge. Le fait de disposer le moyen de chauffage 30, 31 en aval de la vanne de dilatation 10, 20 de la source de gaz 8,28 permet ainsi de réchauffer le flux de gaz 38 qui balaye ensuite toute la conduite de gaz 9 jusqu'à l'arrivée dans l'enceinte 2 de la lampe à décharge luminescente. Ainsi le gaz chauffé désorbe les espèces contaminantes susceptibles de s'être fixées sur la paroi intérieure de la conduite de gaz 9 lors d'une ouverture de l'enceinte 2, par exemple pour changer l'échantillon 4 à analyser.

L'éloignement de la source de chauffage évite aussi que le moyen de chauffage n'élève la température de la lampe à décharge luminescente 1 par rayonnement, ce qui pourrait être nuisible aux composants électroniques et aux joints d'étanchéité de la lampe à décharge.

On injecte le flux de gaz chauffé 38 dans la cellule de décharge pendant une durée D avant d'allumer le plasma d'ablation. Le pompage via les moyens de pompage 7 de l'enceinte 2 est maintenu pendant l'injection du flux de gaz chauffé 38 de manière à évacuer le gaz chauffé et les espèces qui désorbent progressivement des parois de l'enceinte 2, des conduites de gaz 9 et/ou de la surface de l'échantillon 4. La pression dans l'enceinte est maintenue à quelques Torr pendant l'étape de balayage de flux de gaz chauffé.

De façon particulièrement avantageuse, le spectromètre de masse dispose de moyens de pompage différentiel 27. Pendant l'injection de gaz chauffé, on utilise les moyens de pompage différentiel 27 de manière à pomper un flux d'espèces gazeuses 37 à travers l'ouverture 23 entre l'enceinte 2 de la lampe à décharge luminescente et le spectromètre de masse 25. Ce pompage par les moyens de pompage 27 du spectromètre de masse permet de pomper sous un vide plus poussé qu'en utilisant uniquement les moyens de pompage primaire 7 de l'enceinte 2 et permet ainsi d'évacuer des contaminants.

De façon avantageuse, la durée D du balayage d'un flux de gaz chauffé dans la source avant l'allumage du plasma est comprise entre quelques secondes et quelques minutes. Le débit du flux de gaz chauffé est par exemple de l'ordre de 1 litre par minute, ou même inférieur.

Préférentiellement, le gaz chauffé 38 a la même composition chimique que le gaz de plasma 18. Dans ce cas, l'étape c) peut être la continuité de l'étape g), ou, autrement dit, les étapes f) g) et h) peuvent être suivies directement de l'étape d) d'allumage du plasma.

De façon alternative, le gaz chauffé peut être constitué d'un autre gaz ou d'un autre mélange de gaz que le gaz de plasma 18.

Dans un mode de réalisation, le chauffage du gaz à une température T est maintenu pendant le plasma d'ablation. De façon alternative, le chauffage du gaz à une température T est interrompu pendant le plasma d'ablation.

Par exemple, prenons le cas où le gaz de plasma est constitué d'un mélange de gaz provenant de deux bouteilles de gaz différentes 8, 28. Avantageusement, comme illustré sur la figure 3, le moyen de chauffage 30 est disposé en aval de la jonction entre les deux sources de gaz si bien que le mélange de gaz peut être chauffé. Toutefois, pendant la phase d'injection de gaz avant le plasma, il peut être préférable de n'utiliser qu'une seule source de gaz 28, par exemple de l'azote, qui est relativement peu coûteux. Dans ce cas, il peut être suffisant de disposer un moyen de chauffage 31 en aval de la conduite de gaz reliée à la bouteille d'azote 28. Seul le gaz azote est alors chauffé pendant la phase d'injection de gaz chauffé avant allumage du plasma. Pendant le plasma d'ablation, un mélange formé par exemple d'azote et d'un autre gaz peut être injecté dans la lampe à décharge luminescente. Dans ce cas, le gaz du plasma d'ablation peut lui aussi être chauffé grâce au moyen de chauffage 30 ou au contraire n'être pas chauffé.

Le nouveau dispositif proposé présente des avantages de simplicité et de facilité de mise en oeuvre. Un tel dispositif peut très facilement être adapté sur d'anciens appareils déjà installés.

L'injection de gaz chauffé peut être continue ou intermittente. L'injection de gaz chauffé pendant la phase de purge avant la mesure peut avantageusement se poursuivre pendant la mesure par GDMS de l'échantillon, lorsque le gaz chauffé a la même composition que le gaz de plasma.

De manière complémentaire, le dispositif peut comporter des moyens de régulation de la température du gaz, par exemple une sonde de température, disposée dans l'enceinte de la source plasma ou sur une conduite de gaz.

L'échantillon est à une température initiale d'environ 293 K et la source a une température initiale de d'environ 293 K.

Le gaz chaud à la température T a pour effet de chauffer les parois internes de la lampe à décharge luminescente par conduction thermique. L'injection de gaz chaud s'effectue de préférence via le circuit d'injection 9 du gaz de plasma. Ainsi, le gaz chaud a pour effet de chauffer précisément la zone de la surface de l'échantillon 4 qui sera ensuite exposée au plasma d'ablation 5.

De manière surprenante, l'injection de gaz chaud, permet de désorber une grande partie des molécules d'eau adsorbées sur la surface de l'échantillon, sur les parois internes de la lampe à décharge luminescente et probablement dans les tubes de gaz du circuit d'injection. On observe ces effets bien que la température du gaz chaud soit relativement faible, puisqu'une dizaine à une vingtaine de degrés au-dessus de la température ambiante suffit généralement.

Le flux de gaz chaud permet ainsi de nettoyer la surface de l'échantillon et les espèces qui sont désorbées ou dégazées de la surface de l'échantillon sont pompées via les moyens de pompage 7 de l'enceinte et/ou via les moyens de pompage 27 du spectromètre de masse. En particulier, le procédé permet ainsi d'éliminer les molécules d'eau de la surface de l'échantillon. Le flux de gaz chaud est à une température relativement faible qui n'altère généralement pas la surface de l'échantillon. Cette étape permet ensuite d'analyser précisément la composition, notamment en surface, de l'échantillon. Au surplus, l'injection d'un flux de gaz chaud 38 a aussi pour effet de chauffer tout le circuit de distribution de gaz, depuis l'injection, jusqu'au circuit de pompage 7, 27.

Il n'est donc pas nécessaire d'implémenter des moyens de chauffage à haute température pour chauffer toute la source à décharge luminescente.

De façon particulièrement avantageuse, il est possible d'alterner une ou plusieurs séquences d'injection de gaz chaud puis de pompage sous vide primaire ou même sous vide secondaire de manière à évacuer les contaminants et en particulier les molécules d'eau. Cette alternance de purge au gaz chauffé et de pompage permet d'éliminer plus rapidement les contaminants présents sur les parois de l'enceinte et sur la surface de l'échantillon.

Lorsqu'un cycle d'injection de gaz chaud et de pompage sous vide est appliqué avant d'allumer le plasma d'ablation, le pompage s'effectue avantageusement en ouvrant au maximum l'ouverture 23 de type fente disposée entre le spectromètre de masse 23 et la lampe à décharge luminescente de manière à pomper le volume de l'enceinte 2 sous un vide plus poussé qu'un vide primaire. A titre d'exemple illustratif, ce pompage via le spectromètre de masse, en absence d'un plasma de décharge luminescente permet d'atteindre une pression résiduelle d'environ 10⁻⁴ ou 10⁻⁵ Pa.

A la fin des étapes de chauffage d'un flux de gaz à une température T, d'injection du flux de gaz chauffé et de pompage des espèces gazeuses pendant une durée D, il est possible de reprendre le procédé classique d'injection d'un flux de gaz de plasma, d'allumage du plasma d'ablation et de mesure par spectrométrie de masse des espèces ionisées.

Le plasma d'ablation peut ainsi être appliqué à l'échantillon 4 après les étapes f) g) et h) et sans remise à l'air de l'enceinte de la lampe à décharge luminescente, donc sans contamination de la surface de l'échantillon.

De façon complémentaire, il est aussi possible de procéder suite aux étapes f) g) et h) à une ou plusieurs étapes de purge, d'ablation plasma d'un échantillon sacrificiel, par exemple de silicium cristallin, de nettoyage plasma et/ou de refroidissement de la lampe à décharge ou de l'échantillon.

L'effet du procédé d'injection de gaz chaud peut être évalué sur différents exemples d'analyse d'échantillons par spectrométrie de masse à décharge luminescente.

La figure 4 illustre des mesures d'ion H₃0⁺ par GD-TOFMS en fonction du temps, pendant l'exposition d'un échantillon d'inox à un plasma de décharge luminescente. Sur la figure 4, la courbe 43 correspond à la mesure par GD-TOFMS de l'ion H₃0⁺ sans chauffage du gaz de plasma avant son injection dans une lampe à décharge ; la courbe 44 correspond à la mesure par GD-TOFMS de l'ion H₃0⁺ avec chauffage du gaz de plasma avant son injection dans une lampe à décharge. Ces deux courbes 43, 44 sont obtenues toutes choses étant égales par ailleurs : même type d'échantillon, même appareil de GD-TOFMS, même gaz de plasma, mêmes conditions de pression, de débit gazeux, etc.

On observe sur la figure 4, que le niveau de l'ion H₃0⁺ de la courbe 43 « sans injection de gaz chaud avant le plasma d'ablation» est relativement élevé au démarrage du plasma, ce niveau présente un maximum après environ 25 secondes de plasma puis ce niveau baisse en fonction de la durée du plasma d'ablation avec une baisse d'environ 40% au bout de 90 s. Ce signal de l'ion H₃0⁺ reste toutefois très élevé. Le maximum après 25s de plasma d'ablation correspond à la désorption de molécules d'eau induite par le chauffage des parois de la source par le plasma durant la mesure. Un tel maximum pourrait aussi être interprété de manière incorrecte.

Pour la mesure de la courbe 44 « avec injection de gaz chaud avant le plasma d'ablation», l'injection de gaz chaud est effectuée pendant la phase de purge de la lampe à décharge avant le plasma d'érosion. Le flux de gaz chaud est donc mis en contact avec toutes les parois qui interviennent ensuite dans la génération du plasma. Le plasma peut ensuite être allumé avec le même gaz de plasma que le gaz utilisé comme gaz chaud de purge. Avantageusement, le même gaz ou le même mélange de gaz est utilisé pour l'étape d'injection de gaz chaud avant le plasma et comme gaz de plasma pendant l'étape d'érosion par plasma. Dans ce cas, il est préférable de maintenir la température du gaz de plasma à la même température que la température du gaz chaud, afin de stabiliser la température du système.

Par comparaison, on observe sur la courbe 44 « avec injection de gaz chaud » de la figure 4, que le niveau de l'ion H₃0⁺ est considérablement réduit dès le démarrage du plasma (réduction d'un facteur d'environ 10 par rapport au niveau initial de la courbe sans chauffage), ce niveau baissant rapidement dans les vingt premières secondes du plasma pour se stabiliser à un niveau correspondant à quelques pourcents. Le signal de l'ion H₃0⁺ est donc considérablement réduit par l'injection d'un gaz chauffé dans la lampe à décharge luminescente avant le démarrage du plasma d'ablation.

Les signaux de contamination sont divisés par d'un facteur environ égal à 10, ce qui indique une réduction drastique de la contamination par les molécules d'eau.

Un tel résultat n'était nullement prévisible ni attendu, du fait de la relativement faible température du gaz chaud (∼323 K), de la faible pression du gaz dans la source (inférieure à la pression atmosphérique) et de la faible durée de l'étape de purge par injection du gaz chauffé. Par comparaison, les effets du plasma produisent des échanges thermiques directs avec une température de plasma qui peut être très élevée, or on observe que la désorption d'ions dure très longtemps dans un plasma d'ablation sans chauffage du gaz de plasma.

L'étape de chauffage du gaz de plasma peut aussi être combinée avec différents dispositifs et procédés tels que : l'utilisation d'un échantillon sacrificiel, une étape de nettoyage par plasma, de purge des lignes de gaz et de la source.

Selon un mode de réalisation particulier, on utilise un échantillon sacrificiel, par exemple de silicium cristallin, que l'on expose à une purge de gaz chauffé à une température T et pendant une durée D. Cette phase de purge en présence d'un échantillon sacrificiel permet d'évacuer la plupart des molécules contaminantes, sans risquer d'exposer l'échantillon à analyser. On effectue une ou plusieurs séquences de purge éventuellement alternées avec des étapes de pompage de l'enceinte de la lampe à décharge luminescente sous vide primaire. L'utilisation d'un échantillon sacrificiel est particulièrement intéressante dans le cas où l'échantillon à analyser est très fragile (matériau organique, couches minces...) et ne supporte pas une température de gaz de plasma élevée, contrairement à l'échantillon sacrificiel. Il est alors avantageux de purger la lampe à décharge luminescente en présence d'un échantillon sacrificiel en injectant le gaz chauffé à une température aussi élevée que possible (370-400 K).

Puis, on allume le plasma d'ablation de manière à exposer la surface de l'échantillon sacrificiel. Par spectrométrie dé décharge luminescente en présence de l'échantillon sacrificiel, il est possible de détecter la présence de contaminants résiduels, d'identifier et de mesurer la quantité de ces contaminants résiduels. De manière connue en soi, l'érosion sur un échantillon sacrificiel, par exemple de silicium, permet de déposer une couche d'éléments connus sur les parois de la lampe à décharge luminescente. A partir de cette mesure par GD-TOFMS sur un échantillon sacrificiel, il est ensuite possible, si nécessaire, de renouveler la ou les étapes de purge par un gaz chaud. Ensuite, on remplace l'échantillon sacrificiel par l'échantillon à analyser. Une étape de purge avec gaz chauffé est appliquée en présence de l'échantillon à analyser. Dans le cas d'un échantillon peu résistant à la température, la surface de l'échantillon à analyser est nettoyée en faisant passer un flux de gaz à une température plus modérée (par exemple d'environ 320 K) qu'en présence de l'échantillon sacrificiel.

On observe l'impact très important de la contamination par les espèces adsorbées notamment GD TOFMS, L'injection de gaz chaud avant le plasma permet une forte réduction des contaminations (signaux résiduels de O, H et OH).

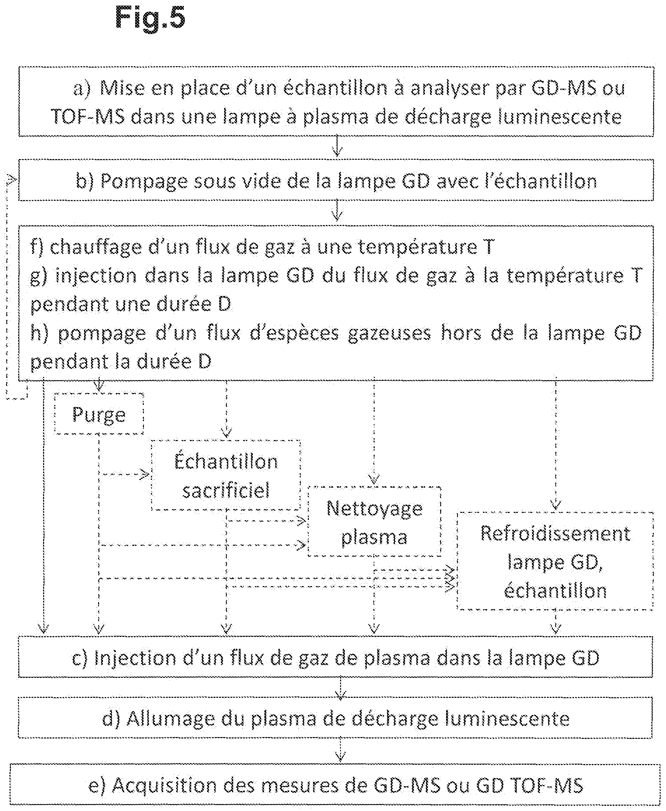

La figure 5 représente schématiquement un diagramme d'étapes de procédé de spectrométrie de masse à décharge luminescente selon un mode de réalisation préféré (représenté par des flèches et blocs en traits pleins) différentes variantes du procédé de l'invention (flèches et blocs en tirets).

L'étape a) est une étape classique de mise en place de l'échantillon dans l'enceinte 2 d'une lampe à décharge luminescente 1. Généralement l'échantillon est appliqué contre un joint d'étanchéité pour refermer l'enceinte à vide 2.

L'étape b) est aussi une étape classique de pompage sous vide de lampe à décharge luminescente 1 en présence de l'échantillon 4.

A la place de l'étape classique de purge de la lampe à décharge en présence de l'échantillon, par injection d'un flux de gaz de plasma et pompage de ce flux de gaz de plasma pendant une durée D avant l'allumage du plasma, le procédé comporte les étapes suivantes :
f) chauffage d'un flux de gaz à une température T ;
g) injection dans la lampe à décharge d'un flux de gaz à la température T pendant une durée D et
h) pompage d'un flux d'espèces gazeuses hors de la lampe à décharge luminescente pendant au moins la durée D.

L'invention repose ainsi sur l'injection d'un gaz chauffé, de préférence le gaz du plasma, qui est chauffé préalablement à son injection dans la lampe à décharge luminescente.

Le procédé classique peut ensuite reprendre par l'injection du gaz de plasma dans la lampe à décharge (étape c), l'allumage du plasma d'ablation (étape d) et, de manière concomitante avec les étapes c) et d), l'acquisition des mesures de spectrométrie de masse, de type HR-GD-MS ou à temps de vol GD-TOFMS (étape e).

De manière complémentaire, le procédé peut comprendre une étape de purge de la lampe à plasma, par exemple lorsque le gaz utilisé pour les étapes f) à h) est différent du gaz de plasma.

Par exemple, cette étape de purge consiste suite à l'étape h) à interrompre l'injection du flux de gaz chauffé dans la cellule et à pomper sous vide la cellule, avant de passer aux étapes c) d'injection d'un flux de gaz de plasma et d) d'allumage du plasma d'ablation. De façon particulièrement avantageuse, dans le cas d'un spectromètre de masse à temps de vol, on ouvre la fente (23) disposée entre le spectromètre de masse à temps de vol et la lampe à décharge de manière à utiliser les moyens de pompage différentiel (27) du TOFMS pour pomper la cellule sous un vide pouvant atteindre 10⁻⁴ à 10⁻⁵ Torr. Dans une variante, les étapes f)g)h) et une étape de pompage sous vide sont répétées cycliquement avant d'appliquer les étapes c) d'injection du gaz de plasma et d) d'allumage du plasma. Le fait d'appliquer un ou plusieurs cycles d'injection de gaz chauffé puis de pompage sous vide permet d'accélérer le procédé de décontamination de la lampe à décharge et de la surface de l'échantillon et d'atteindre un niveau de contamination résiduelle plus faible.

Dans une variante, le procédé comporte en outre une étape d'ablation d'un échantillon sacrificiel, par exemple de silicium cristallin, afin de recouvrir les parois internes de la lampe à décharge d'une couche inerte connue. Dans une autre variante, le procédé comporte en outre une étape de nettoyage plasma de la lampe, par exemple en cachant l'échantillon derrière un obturateur. Dans une autre variante, le procédé comporte en outre une étape de refroidissement de l'échantillon, avant d'allumer le plasma d'ablation, afin de maintenir constante la température de l'échantillon pendant son exposition au plasma d'ablation. Ces variantes peuvent être utilisées seules ou en combinaison.

Le dispositif et le procédé de l'invention impliquent peu de modifications sur une lampe à décharge classique car n'impliquent pas de contrainte de vide poussé, ni de contrainte liée à une gamme de température étendue. Le procédé de chauffage d'un flux de gaz consomme peu d'énergie et les étapes f) g) et h) ne consomment pas de temps supplémentaire d'utilisation du dispositif.

En effet, les étapes f) g) et h) sont de préférence effectuées pendant la phase de purge classique d'une lampe à décharge luminescente, ce qui évite de rallonger le temps nécessaire à l'analyse d'un échantillon. Le procédé est compatible avec une cadence de mesure élevée, allant jusqu'à plusieurs dizaines d'échantillons à l'heure. Aucun temps mort de remise à température ambiante d'un échantillon refroidi à basse température n'est nécessaire.

L'invention s'applique notamment à une lampe à décharge couplée à un spectromètre de masse à temps de vol (TOFMS), à un spectromètre de masse à secteur magnétique ou encore à un spectromètre de masse quadripolaire ou à tout autre modèle de spectromètre de masse.

## Revendications

1. Procédé de spectrométrie de masse à décharge luminescente comprenant les étapes suivantes :
a. Mise en place d'un échantillon (4) à analyser par spectrométrie de masse à décharge luminescente dans une cellule (2) d'une lampe à décharge luminescente (1) ;
b. Pompage d'un flux d'espèces gazeuses (17) hors de ladite cellule ;
c. Injection d'un flux de gaz de plasma (8) dans ladite cellule (2) ;
d. Application d'une puissance électrique (6) sur les électrodes (3, 13) de la cellule (2) de décharge luminescente de manière à allumer un plasma d'ablation (5) en surface de l'échantillon (4) à analyser ;
e. Détection des espèces ionisées (14) du plasma, analyse desdites espèces ionisées et mesure des espèces détectées par spectrométrie de masse à décharge luminescente ;
**caractérisé en ce que** ledit procédé de spectrométrie de masse à décharge luminescente comporte en outre les étapes suivantes :
f. chauffage d'un flux de gaz (18) à une température T supérieure à la température ambiante,
g. Injection, dans la cellule (2) de décharge luminescente, dudit flux de gaz (18) chauffé à la température T pendant une durée D avant l'étape d) d'allumage du plasma d'ablation, et
h. pompage d'un flux d'espèces gazeuses (17, 37) hors de ladite cellule pendant la durée D, de manière à décontaminer la surface de l'échantillon et/ou les parois internes de la cellule de décharge luminescente avant l'allumage du plasma d'ablation.

2. Procédé de spectrométrie de masse à décharge luminescente selon la revendication 1, dans lequel le gaz (18) chauffé injecté à l'étape g) a la même composition chimique que le gaz de plasma (8), de préférence choisi parmi un gaz rare ou un mélange de gaz rares ou un mélange d'un gaz rare et d'un autre gaz.

3. Procédé de spectrométrie de masse à décharge luminescente selon la revendication 1, dans lequel le gaz (18) chauffé injecté à l'étape g) a une composition chimique différente du gaz de plasma (8).

4. Procédé de spectrométrie de masse à décharge luminescente selon l'une des revendications 1 à 3 dans lequel la température T du gaz chauffé est comprise entre 300 K et 400 K et de préférence d'environ 323 ± 10 K.

5. Procédé de spectrométrie de masse à décharge luminescente selon l'une des revendications précédentes comprenant en outre suite à l'étape h) une étape d'interruption de l'injection d'un flux de gaz (38) dans la cellule et une étape de pompage sous vide de la cellule (2) avant les étapes c) d'injection d'un flux de gaz de plasma et d) d'allumage du plasma d'ablation.

6. Procédé de spectrométrie de masse à temps de vol selon la revendication 5 dans lequel l'étape de pompage sous vide de la cellule (2) comprend l'ouverture d'une fente (23) disposée entre la cellule (2) et le spectromètre de masse à temps de vol (25) et le pompage sous vide de ladite cellule via des moyens de pompage (27) du spectromètre de masse à temps de vol.

7. Dispositif de spectrométrie de masse à décharge luminescente comprenant :
- une lampe à décharge luminescente (1), comprenant une cellule (2) de décharge luminescente, des électrodes (3, 13), et une source d'alimentation électrique (6) adaptée pour appliquer une puissance électrique sur les électrodes (3, 13) de la cellule de décharge luminescente, des moyens d'injection d'un flux de gaz (18, 38) dans la cellule (2) de décharge luminescente, lesdits moyens d'injection étant reliés à la cellule de décharge luminescente par des moyens de raccordement fluidiques et des moyens de pompage (7, 27) d'un flux d'espèces gazeuses (17, 37) hors de la cellule (2) de décharge luminescente, ladite lampe à décharge luminescente (1) étant adaptée pour former un plasma d'ablation (5) en surface d'un échantillon (4) à analyser en présence d'un flux de gaz de plasma (8) dans la cellule (2) de décharge luminescente,
- un spectromètre de masse (25) comprenant un détecteur (22) adapté pour détecter des espèces ionisées (14) du plasma (5),
**caractérisé en ce que** le dispositif de spectrométrie de masse à décharge luminescente comporte :
- des moyens de chauffage (30, 31) adaptés pour chauffer un flux de gaz (38) en amont de ladite cellule (2) de décharge luminescente, les moyens d'injection de gaz étant adaptés pour injecter, dans la cellule de décharge luminescente, un flux de gaz (38) chauffé à la température T pendant une durée D, et **en ce que** les moyens de pompage (7, 27) sont configurés pour pomper un flux d'espèces gazeuses (17, 37) hors de ladite cellule (2) pendant la durée D, de manière à décontaminer la surface de l'échantillon et/ou les parois internes de la cellule de décharge luminescente avant l'allumage du plasma d'ablation.

8. Dispositif de spectrométrie de masse à décharge luminescente selon la revendication 7, dans lequel les moyens de chauffage (30, 31) sont adaptés pour chauffer un flux de gaz (38) à une température comprise entre 300 K et 400 K et de préférence d'environ 323 ± 10 K.

9. Dispositif de spectrométrie de masse à décharge luminescente selon la revendication 7 ou 8 dans lequel les moyens de chauffage (30, 31) d'un flux de gaz (38) comprennent une résistance électrique chauffante, une source de flux d'air chauffé ou une source de liquide chauffé, lesdits moyens de chauffage (30, 31) étant disposés au voisinage d'une conduite de gaz (9) reliant une source de gaz (8, 28) à la cellule (2) de décharge luminescente.

10. Dispositif de spectrométrie de masse à décharge luminescente selon l'une des revendications 7 à 9 comportant en outre des moyens de refroidissement adaptés pour refroidir l'échantillon et/ou la cellule de décharge luminescente.

## Patentansprüche

1. Glimmentladungsmassenspektrometrieverfahren mit den folgenden Schritten:
a. Einbringen einer mittels Glimmentladungsmassenspektrometrie zu analysierenden Probe (4) in eine Zelle (2) einer Glimmentladungslampe (1),
b. Abpumpen eines Flusses gasförmiger Materien (17) nach außerhalb der Zelle,
c. Einleiten eines Plasmagasflusses (8) in die Zelle (2),
d. Anlegen einer elektrischen Leistung (6) an die Elektroden (3, 13) der Glimmentladungszelle (2), um ein Ätzplasma (5) an der Oberfläche der zu analysierenden Probe (4) zu zünden,
e. Erfassen der ionisierten Materien (14) des Plasmas, Analyse der ionisierten Materien und Messen der erfaßten Materien durch Glimmentladungsmassenspektrometrie,
**dadurch gekennzeichnet, daß** das Glimmentladungsmassenspektrometrieverfahren außerdem die folgenden Schritte aufweist:
f. Erhitzen eines Gasflusses (18) auf eine Temperatur T oberhalb der Umgebungstemperatur,
g. Einleiten des auf die Temperatur T erhitzten Gasflusses (18) in die Glimmentladungszelle (2) während einer Dauer D vor dem Schritt d) des Zündens des Ätzplasmas,
h. Abpumpen eines Flusses gasförmiger Materien (17, 37) nach außerhalb der Zelle während der Dauer D, um die Oberfläche der Probe und/oder die Innenwände der Glimmentladungszelle vor dem Zünden des Ätzplasmas zu reinigen.

2. Glimmentladungsmassenspektrometrieverfahren gemäß Anspruch 1, bei dem das beim Schritt g) eingeleitete erhitzte Gas (18) die gleiche chemische Zusammensetzung aufweist wie das vorzugsweise aus einem Edelgas oder einer Mischung von Edelgasen oder einer Mischung eines Edelgases mit einem anderen Gas ausgewählte Plasmagas (8).

3. Glimmentladungsmassenspektrometrieverfahren gemäß Anspruch 1, bei dem das beim Schritt g) eingeleitete erhitzte Gas (18) eine andere chemische Zusammensetzung aufweist als das Plasmagas (8).

4. Glimmentladungsmassenspektrometrieverfahren gemäß einem der Ansprüche 1 bis 3, bei dem die Temperatur T des erhitzten Gases zwischen 300 K und 400 K liegt und vorzugsweise ungefähr 323 ± 10 K beträgt.

5. Glimmentladungsmassenspektrometrieverfahren gemäß einem der vorangehenden Ansprüche, das außerdem nach dem Schritt h) einen Schritt des Unterbrechens des Einleitens eines Gasstroms (38) in die Zelle und einen Schritt des Leerpumpens der Zelle (2) bis zum Vakuum vor den Schritten c) des Einleitens eines Plasmagasflusses und d) des Zündens des Ätzplasmas aufweist.

6. Flugzeitmassenspektrometrieverfahren gemäß Anspruch 5, bei dem der Schritt des Leerpumpens der Zelle (2) bis zum Vakuum das Öffnen eines zwischen der Zelle (2) und dem Flugzeitmassenspektrometer (25) angeordneten Spalts (23) und das Leerpumpen der Zelle bis zum Vakuum durch Pumpmittel (27) des Flugzeitmassenspektrometers aufweist.

7. Glimmentladungsmassenspektrometrievorrichtung mit
- einer Glimmentladungslampe (1), die eine Glimmentladungszelle (2), Elektroden (3, 13) und eine zum Anlegen einer elektrischen Leistung an die Elektroden (3, 13) der Glimmentladungszelle ausgelegte elektrische Versorgungsquelle (6) aufweist, Mitteln zum Einleiten eines Gasflusses (18, 38) in die Glimmentladungszelle (2), wobei die Mittel zum Einleiten mit der Glimmentladungszelle durch fluidische Verbindungsmittel und Mittel (7, 27) zum Abpumpen eines Flusses gasförmiger Materien (17, 37) nach außerhalb der Glimmentladungszelle (2) verbunden sind, wobei die Glimmentladungslampe (1) dazu ausgelegt ist, ein Plasma (5) zum Abätzen der Oberfläche einer zu analysierenden Probe (4) in Gegenwart eines Plasmagasflusses (8) in der Glimmentladungszelle (2) zu bilden,
- einem Massenspektrometer (25), das einen Sensor (22) aufweist, der dazu ausgelegt ist, ionisierte Materien (14) des Plasmas (5) zu erfassen,
**dadurch gekennzeichnet, daß** die Glimmentladungsmassenspektrometrievorrichtung
- Heizmittel (30, 31) aufweist, die dazu ausgelegt sind, einen Gasfluß (38) vor der Glimmentladungszelle (2) aufzuheizen, wobei die Mittel zum Einleiten des Gases dazu ausgelegt sind, in die Glimmentladungszelle einen auf die Temperatur T erhitzten Gasfluß (38) während einer Dauer D einzuleiten, und daß die Pumpmittel (7, 27) dazu ausgelegt sind, einen Fluß gasförmiger Materien (17, 37) während der Dauer D nach außerhalb der Zelle (2) zu pumpen, um die Oberfläche der Probe und/oder die Innenwände der Glimmentladungszelle vor dem Zünden des Ätzplasmas zu reinigen.

8. Glimmentladungsmassenspektrometrievorrichtung gemäß Anspruch 7, bei dem die Heizmittel (30, 31) dazu ausgelegt sind, einen Gasfluß (38) auf eine Temperatur zwischen 300 K und 400 K und vorzugsweise ungefälar 323 ± 10 K zu erhitzen.

9. Glimmentladungsmassenspektrometrievorrichtung gemäß Anspruch 7 oder 8, bei dem die Mittel (30, 31) zum Aufheizen eines Gasflusses (38) einen elektrischen Heizwiderstand, eine Quelle für einen Strom erhitzter Luft oder eine Quelle für eine erhitzte Flüssigkeit aufweisen, wobei die Heizmittel (30, 31) in der Nähe einer Gasleitung (9) angeordnet sind, die eine Gasquelle (8, 28) mit der Glimmentladungszelle (2) verbindet.

10. Glimmentladungsmassenspektrometrievorrichtung gemäß einem der Ansprüche 7 bis 9, die außerdem Kühlmittel aufweist, die dazu ausgelegt sind, die Probe und/oder die Glimmentladungszelle zu kühlen.

## Claims

1. A glow discharge mass spectrometry method comprising the following steps:
a. placing a sample (4) to be analysed by glow discharge mass spectrometry in a cell (2) of a glow discharge lamp (1);
b. pumping a flow of gaseous species (17) out of said cell;
c. injecting a flow of plasma gas (8) into said cell (2);
d. applying an electric power (6) to the electrodes (3, 13) of the glow discharge cell (2) so as to light an ablation plasma (5) at the surface of the sample (4) to be analysed;
e. detecting ionized species (14) of the plasma, analysing said ionized species and measuring the species detected by glow discharge mass spectrometry;
**characterized in that** said glow discharge mass spectrometry method further includes the following steps:
f. heating a gas flow (18) to a temperature T higher than the ambient temperature,
g. injecting, into the glow discharge cell (2), said flow of gas (18) heated to the temperature T for a duration D before the step d) of lighting the ablation plasma, and
h. pumping a flow of gaseous species (17, 37) out of said cell for the duration D, so as to decontaminate the surface of the sample and/or the internal walls of the glow discharge cell before the lighting of the ablation plasma.

2. The glow discharge mass spectrometry method according to claim 1, wherein the heated gas (18) injected at step g) has the same chemical composition as the plasma gas (8), preferably chosen among a rare gas, or a mixture of rare gases, or a mixture of a rare gas with another gas.

3. The glow discharge mass spectrometry method according to claim 1, wherein the heated gas (18) injected at step g) has a chemical composition different from that of the plasma gas (8).

4. The glow discharge mass spectrometry method according to one of claims 1 to 3, wherein the temperature T of the heated gas is comprised between 300 K and 400 K, and preferably of about 323 ± 10 K.

5. The glow discharge mass spectrometry method according to one of the preceding claims, further comprising, after the step h), a step of interrupting the injection of a gas flow (38) into the cell and a step of vacuum pumping the cell (2) before the steps c) of injecting a flow of plasma gas and d) of lighting the ablation plasma.

6. The glow discharge mass spectrometry method according to claim 5, wherein the step of vacuum pumping the cell (2) comprises the opening of a slit (23) arranged between the cell (2) and the time-of-flight mass spectrometer (25) and the vacuum pumping of said cell via pumping means (27) of the time-of-flight mass spectrometer.

7. A glow discharge mass spectrometry device comprising:
- a glow discharge lamp (1), comprising a glow discharge cell (2), electrodes (3, 13), and an electric supply source (6) adapted to apply an electric power to the electrodes (3, 13) of the glow discharge cell, means for injecting a gas flow (18, 38) into the glow discharge cell (2), said injection means being connected to the glow discharge cell by fluid connection means and means (7, 27) for pumping a flow of gaseous species (17, 37) out of the glow discharge cell (2), said glow discharge lamp (1) being adapted to form an ablation plasma (5) at the surface of a sample (4) to be analysed in the presence of a flow of plasma gas (8) in the glow discharge cell (2),
- a mass spectrometer (25) comprising a detector (22) adapted to detect ionized species (14) of the plasma (5),
**characterized in that** the glow discharge mass spectrometry device includes:
- heating means (30, 31) adapted to heat a gas flow (38) upstream from said glow discharge cell (2), the gas injection means being adapted to inject, into the glow discharge cell, a flow of gas (38) heated to the temperature T for a duration D, and **in that** the pumping means (7, 27) are configured to pump a flow of gaseous species (17, 37) out of said cell (2) for the duration D, so as to decontaminate the surface of the sample and/or the internal walls of the glow discharge cell before the lighting of the ablation plasma.

8. The glow discharge mass spectrometry device according to claim 7, wherein the heating means (30, 31) are adapted to heat a flow of gas (38) to a temperature comprised between 300 K and 400 K, and preferably of about 323 ± 10 K.

9. The glow discharge mass spectrometry device according to claim 7 or 8, wherein the means (30, 31) for heating a flow of gas (38) comprise a heating electric resistance, a source of heated air flow or a source of heated liquid, said heating means (30, 31) being arranged in the vicinity of a gas duct (9) connecting a source of gas (8, 28) to the glow discharge cell (2).

10. The glow discharge mass spectrometry device according to one of claims 7 to 9, further comprising cooling means adapted to cool down the sample and/or the glow discharge cell.
